# EUROPÄISCHE PATENTANMELDUNG

(11) **EP 1 285 892 A2**
(43) Veröffentlichungstag der Anmeldung: **26.02.2003**
(21) Anmeldenummer: 02017899.2
(22) Anmeldetag: 09.08.2002
(51) Int. Cl.: C03C 17/02, C03C 3/32

(54) **Cadmiumfreie optische Steilkantenfilter**

(30) Priorität: 22.08.2001 DE 10141102
(71) Anmelder: Schott Glas, 55122 Mainz (DE); CARL-ZEISS-STIFTUNG trading as SCHOTT GLAS, 55122 Mainz (DE)
(72) Erfinder: Kolberg, Uwe, Dr., 55252 Mainz-Kastel (DE); Speit, Burkhard, Dr., 07745 Jena (DE); Vogt, Helge, 55299 Nackenheim (DE); Schock, Hans-Werner, Prof. Dr., 70563 Stuttgart (DE); Ritter, Simone, Dr., 55116 Mainz (DE); Köble, Christine, Camarillo, CA 93012 (US); Schäffler, Raymund, 70771 Leinfelden-Echterdingen (DE)
(74) Vertreter: Sawodny, Michael-Wolfgang

(57) **Zusammenfassung**

Die Erfindung betrifft cadmiumfreie optische Steilkantenfilter umfassend I-III-VI-Verbindungshalbleitersysteme mit stöchiometrischer oder nichtstöchiometrischer Zusammensetzung wobei die I-III-VI-Verbindungshalbleiter Systeme mit einem oder mehreren der nachfolgenden Elemente
für die einwertigen (I)-Elemente: Cu, Ag
für die dreiwertigen (III)-Elemente: Al, In, Ga
für die sechswertigen (VI)-Elemente: S, Se, Te
sind.

## Beschreibung

Die Erfindung betrifft cadmiumfreie optische Steilkantenfilter gemäß dem Oberbegriff des Anspruchs 1 sowie ein Verfahren zu deren Herstellung.

Optische Steilkantenfilter zeichnen sich durch charakteristische Transmissionseigenschaften aus. So zeigen sie im kurzwelligen Bereich eine niedrige Transmission, die über einen schmalen Spektralbereich zu hoher Transmission ansteigt und im Langwelligen hoch bleibt. Der Bereich niedriger Transmission wird als Sperrbereich bezeichnet, der Bereich hoher Transmission als Paß- oder Durchlaßbereich.

Zur Charakterisierung von optischen Steilkantenfiltern werden die nachfolgenden Kenngrößen verwandt.
- die Kantenwellenlänge λ_{C}: Sie entspricht der Wellenlänge, bei der der spektrale Reintransmissionsgrad zwischen Sperr- und Durchlaßbereich die Hälfte des Maximalwertes beträgt.
- der Sperrbereich: Im Sperrbereich wird der Reintransmissionsgrad Tᵢₛ von 10⁻⁵ nicht überschritten. Dieser Bereich beginnt üblicherweise ca. 40 bis 60 nm unterhalb λ_{C}.
- der Paßbereich: Im Paßbereich wird der Reintransmissionsgrad τᵢₚ von 0,99 nicht unterschritten. Dieser Bereich beginnt ca. 40 bis 60 nm oberhalb von λ_{C}.

Ein typisches Beispiel für einen Steilkantenfilter gemäß dem Stand der Technik stellt das Schott-Glas OG 590 dar. Bei diesem Glas beträgt λ_{C} 590 nm. Der Sperrbereich wird unterhalb 540 nm (τᵢₛ, _{540 nm} = 10⁻⁵) und der Paßbereich oberhalb 640 nm (τ_{ip, 640 nm} = 0,99) erreicht.

Abweichend von den zuvor gemachten Angaben können bei Filtergläsern mit einer Kantenwellenlänge im nahen IR die Abstände für τᵢₛ und τᵢₚ von λ_{C} auch größer als 40 bis 60 nm sein.

Optische Steilkantenfilter gemäß dem Stand der Technik umfassen Gläser auf Cadmiumsulfid-, -selenid- und/oder -tellurid-Basis, wie sie beispielsweise in DE-OS 20 26 485 und DE-PS 26 21 741 beschrieben sind. Die Farbwirkung, die die Funktion als Filter mit Absorptionssteilkanten im Spektralbereich zwischen 455 und 850 nm ermöglicht, beruht auf Halbleiter-Partikeln, beispielsweise mikrokristallinem (Zn, Cd) (S, Se, Te) mit einer Partikelgröße von 1-10 nm in einer Glasmatrix.

Nachteilig an den bisherigen Steilkantenfiltern ist, daß sie giftige und krebserregende Cd-Verbindungen enthalten, was aufwendige Sicherheits- und Schutzmaßnahmen bsp. bei der Gemengezubereitung, Nachverarbeitung und Entsorgung erforderlich macht.

Nachteilig ist weiterhin, daß die Kantenwellenlänge nur innerhalb des genannten Spektralbereiches im Sichtbaren und im nahen Infrarot variiert werden kann. Insbesondere für Filter für IR-Scheinwerfer, Substrate für IR Bandpaßfilter und Filter zur Abdeckung von IR-LED sind Steilkantenfilter im längerwelligen InfrarotBereich erwünscht.

Ein Bandpaßfilter für ein Raman-Spektrometer umfassend ein I-III-VI₂-Einkristall ist aus der JP 03-277928 bekannt geworden.

Der wichtigste Unterschied zwischen einem Bandpaßfilter und einem Steilkantenfilter, wie in vorliegender Erfindungbeansprucht, ist das physikalische Grundprinzip und damit der Absorptions- und Paßbereich.

Bandpassfilter können beispielsweise durch lonendotierung oder Interferenzschichten erzeugt werden, deren Lage und Halbwertsbreite von der lonenart, Ionen-Konzentration bzw. der Schichtenart, Schichtenanzahl und Schichtdicke abhängt. Die Elektronenübergänge, die für die Absorptionsbanden verantwortlich sind, können mit der Ligandenfeldtheorie erklärt werden. Es kommt dabei zu Elektronenübergängen an einzelnen Wellenlängen, die genau der Energie entspricht, um das Elektron von den energetisch abgesenkten Orbitalen zu den energetisch angehobenen Orbitalen zu transportieren. Es kommt zur Absorption bei genau dieser Wellenlänge und damit zur Bildung einer Bande im Transmissionsspektrum.

Bei einem Kantenfilter finden Elektronenübergänge zwischen einem Leitungsband und einem Valenzband statt. Die Energie des Lichtes muß größer als die Bandlücke zwischen Valenz- und Leitungsband sein, damit es zu e-Übergängen kommt. Das Licht, das Energien kleiner als die Bandlücke besitzt, führt nicht zu Elektronenübergängen. Es kommt somit nicht zu selektiven Elektronenübergängen an bestimmten Wellenlängen, sondern zu Elektronenübergängen und damit zur Absorption bis zu einer bestimmten Wellenlänge, die gerade noch von der Energie-der Bandlücke entspricht. Diese bestimmte Wellenlänge stellt die Kante des Filters dar.

Es ist Aufgabe der Erfindung cadmiumfreie, optische Steilkantenfilter mit guter Sperrung im kurzwelligen und hoher Transmission im längerwelligen Bereich bereitzustellen, deren Kante über einen weiteren Wellenlängenbereich einstellbar ist und die umweltfreundlich und einfach herstellbar sind. Insbesondere sollen die Nachteile, die bei optischen Steilkantenfiltern gemäß dem Stand der Technik auftreten, vermieden werden.

Diese Aufgabe wird durch optische Steilkantenfilter gemäß dem Anspruch 1 gelöst.

Erfindungsgemäß umfassen die optischen Steilkantenfilter I-III-VI Verbindungshalbleiter, wobei die I-III-VI-Verbindungshalbleiter (Cu, Ag)-(In, Ga, Al)-(S, Se, Te)-Systeme sind.

Die Verbindungen können sowohl stöchiometrische als auch nichtstöchiometrische Zusammensetzungen aufweisen. Die Verbindungen weisen eine mehr oder weniger angenäherte Chalkoyritstruktur bzw. mehr oder weniger stark davon abweichende chemische und strukturelle Variationen auf.

I-III-VI-Halbleiterverbindungen aus dem genannten System sind bekannt. Die bekanntesten sind die Randkomponenten CulnS₂ und CuInSe₂ des Systems Culn (Se₁₋ₓ Sₓ)₂.

Derartige Verbindungshalbleiter und deren Legierungen finden beispielsweise als Absorberschichten auf dem Gebiet der polykristallinen Dünnschichtsolarzellen Anwendung. Auf dem Gebiet der Photovoltaik ist vor allem ein möglichst hoher optischer Absorptionskoeffizient und ein Bandabstand von ca. 1 bis 2 eV von Interesse. Diesbezüglich wird beispielsweise auf "Photovoltaik, Strom aus der Sonne", Technologie, Wirtschaftlichkeit und Marktentwicklung, J. Schmidt (Hrsg.), 3. Auflage-Heidelberg: Müller, 1994 verwiesen, deren Offenbarungsgehalt in die vorliegende Anmeldung vollumfänglich miteingeschlossen wird. Je nach Bandabstand des Halbleiters wird der Wirkungsgrad durch die nicht absorbierten Photonen oder durch die geringe Ausgangsspannung begrenzt. Um möglichst hohe Energieausbeuten zu erreichen, werden Halbleiter mit einem Bandabstand im mittleren Bereich der Photonenenergie im Sonnenspektrum verwendet, d.h. im Bereich 1 bis 1,7 eV.

Mit den Halbleitern Culn (Se₁₋ₓ Sₓ)₂ beschichtete Gläser sind für eine Anwendung in der Photovoltaik beispielsweise aus G. Aren, O.P. Agnihotri, J. Materials Science Letters 12 (1993) 1176 bekanntgeworden.

Die SU 1527199 A1 und SU 1677026 A1 zeigen CuInS₂ dotierte Bulkgläser. Bei diesen Gläsern wird der Band-Gap des Chalkopyrites CuInS₂ bei 1,52 eV für die Anwendung als Filterglas genutzt. Nachteilig an diesen Bulkgläsern ist jedoch, daß eine kontinuierliche Verschiebung der Bandkante nicht möglich ist. Außerdem ist die Herstellung dieser Gläser schwierig, da bei den zum Erschmelzen des Materials nötigen hohen Temperaturen ein großer Teil der Halbleiter verdampft oder oxidativ zersetzt wird. Außerdem ist der Anlaufprozeß, d.h. das gezielte Ausscheiden kleinster Halbleiterkristalle bei einem Dreistoffsystem (CuInS₂) nur schwierig zu beherrschen.

Die Erfinder haben überraschenderweise herausgefunden, daß das Aufbringen von Verbindungshalbleitem der Klasse I-III-VI auf hochtransparenten Substraten mit geringem Brechungsindex sowie ggf. einer Antireflexschicht bzw. einem Antireflexschichtsystem sowie ggf. einer Schutzschicht zur Hersteilung Cd-freier Steilkantenfilter mit Kantenwellenlängen im Bereich von 460 bis 1240 nm hervorragend geeignet ist. Die optischen Eigenschaften dieser (Cu, Ag) (In, Ga, Al) (S, Se)-Schichten ermöglichen es, die herkömmlichen, mit toxischen Elementen wie Cadmium dotierten Filter zu ersetzen und darüber hinaus die Steilkante in Wellenlängenbereiche insbesondere > 850 nm zu verschieben, die mit konventionellen Steilkantenfiltern nicht erreichbar sind.

Dünnschichten aus Verbindungshalbleitem der Klasse I-III-VI auf einem transparenten Substrat ermöglichen Absorptionskanten in einem weiten Spektralbereich von 460 bis 1240 nm durch Zusammensetzungsvariation, unterschiedliche Stöchiometrie der Verbindungshalbleiter der Klasse I-III-VI und die Einstellung unterschiedlicher Parameter während des Aufdampfprozesses. Zum simultanen Aufbringen der Elemente im Hochvakuum wird bevorzugt die physikalische Abscheidung aus der Dampfphase, die sog. Physical Vapor Deposition (PVD) eingesetzt.

Als Substrate können Kunststoffsubstrate oder Glassubstrate eingesetzt werden. Besonders bevorzugt sind Substrate mit sehr guter Transmission. Als Glassubstrate besonders bevorzugt sind Kalk-Natron-Gläser, ganz besonders bevorzugt sind Aluminiumborosilikatgläser.

Die Substrate weisen eine möglichst glatte Oberfläche auf. Bei zu rauhen Oberflächen tritt Streuung auf, was zur Verschlechterung der Transmission führt.

Um eine optimale UV-Blockung zu erreichen, kann in einer besonders bevorzugten Ausführungsform vorgesehen sein, daß das eingesetzte Glassubstrat ein Ti-dotiertes Glas ist, beispielsweise ein Kalk-Natron oder ein Aluminiumborosilikatglas.

Zur besseren Haftung der auf das Substrat aufgebrachten Schicht wird dieses mit Standardreinigungsprozessen behandelt, beispielsweise mit bidestilliertem H₂O. Am Substrat nach der Reinigung noch anhaftendes H₂O kann durch eine Plasmabehandlung im Vakuum beseitigt werden.

Zur Haftverbesserung können in einer weitergebildeten Ausführungsform der Erfindung transparente Haftvermittler eingesetzt werden, wie beispielsweise ZnO.

Die Erfindung soll nachfolgend anhand der Ausführungsbeispiele und der Zeichnungen beispielhaft beschrieben werden.

Es zeigen:

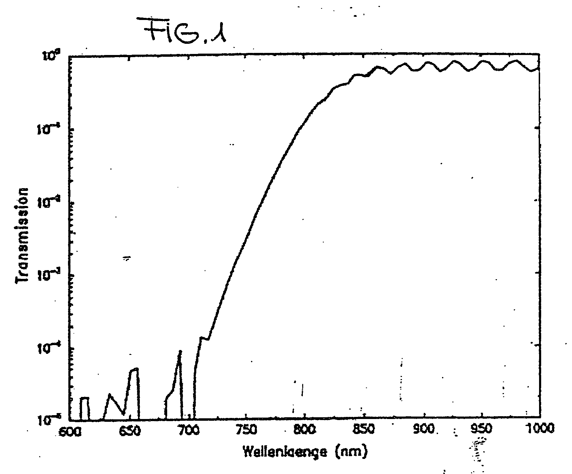

- Figur 1: die Transmissionskurve einer (Cu, Ag) (In, Ga) (S, Se)-Schicht auf einem transparenten Glassubstrat mit einer Antireflexbeschichtung.

Als ein erstes erfindungsgemäßes Materialsystem wird das Materialsystem Cu-In-S beschrieben, das auch kurz als CIS-System bezeichnet wird, das bei zwei Schichtdicken (300 bis 400 nm und ca. 1000 nm) und zwei Substrattemperaturen (250 und 600° C) untersucht wurde. Des weiteren wurde bei diesem System die Zusammensetzung variiert.

Bei einer Substrattemperatur von 600° C und einer Aufdampfzeit von 30 min werden mit In/(In+Cu)-Verhältnissen zwischen 0,51 und 1,0 Bandabstände von 623 nm (1,99 eV) und 860 nm (1,44 eV) erreicht. Für das gleiche Materialsystem werden bei einer Substrattemperatur von 600° C und einer Aufdampfzeit von 15 min mit In/(In+Cu)-Verhältnissen zwischen 0,55 und 0,83 Bandabstände von 746 nm (1,66 eV) und 854 nm (1,45 eV) erreicht.

Der Bandabstand konnte wesentlich vergrößert werden bei einer niedrigeren Substrattemperatur von 250° C. Der Bandabstand lag bei einer Aufdampfzeit von 30 min und einem In/(In+Cu)-Verhältnis von 0,53 bei 866 nm (1,43 eV).

Kombinierte Maxima- bzw. Minimawerte des In/(In+Cu)-Verhältnisses und S/(In+Cu)-Verhältnisses sind nicht immer gleichzusetzen mit Extremlagen der Bandabstände. Das gilt auch für die nachfolgenden Materialsysteme und Aufdampfprozesse.

Die optischen Schichteigenschaften mit In/(In+Cu) ≤ 0,5 werden entscheidend durch die Herstellparameter und ihre Zusammensetzung beeinflußt. Bei gleicher Schichtdicke und einem In/(In+Cu)-Verhältnis von 0,5 bis 1 nimmt die Steilheit der Bandkante mit abnehmendem Indium-Anteil deutlich zu. Die Steilheit der Bandkante ist ein Qualitätskriterium für Steilkantenfilter und kann somit über den In-Gehalt eingestellt werden. Ein In/(In+Cu)-Verhältnis unter 0,5 ist jedoch für den Paßbereich des Filters ungünstig. Bei einem In/(In+Cu)-Verhältnis kleiner 0,5 werden Schichten nahe der Stöchiometrie und im Kupferreichen kristallisiert, wodurch die Schicht stärker streut. Die Streuung wirkt sich wiederum negativ auf die Transmission aus, d.h. die Transmission sinkt im Paßbereich unter 80 %. Außerdem wird über den Indium-Anteil die Lage der Bandkante eingestellt, d.h. je indiumreicher die Schichten sind, desto größer wird das Band-Gap und die Bandkante des Filters verschiebt sich zu kürzeren Wellenlängen. Der Zusammensetzungsbereich der Schichten mit einem In/(In+Cu)-Verhältnis von 0,5 bis 1 ist für die Anwendung als Steilkantenfilter besonders vorteilhaft, um die Lage der Bandkante, den Sperrbereich und den Paßbereich entsprechend einzustellen.

Die Bandkante verschiebt sich in Richtung kürzere Wellenlängen durch Zugabe von Gallium zum Cu-In-S-System. Dabei bewegt sich das (In+Ga)/(In+Ga+Cu)-Verhältnis zwischen 0,51 und 0,66 und das Ga/(In+Ga)-Verhältnis zwischen 0 und 1. Bei einer Substrattemperatur von 600° C und einer Aufdampfzeit von 30 min sind Bandabstände zwischen 685 nm (1,81 eV) und 805 nm (1,54 eV) präparierbar. Geringer wird der Bandabstand wiederum bei einer geringeren Temperatur (550° C) und kürzerer Aufdampfzeit (13 min). Die Bandabstände liegen dann zwischen 506 (2,44 eV) und 708 nm (1,75 eV).

Auch hier gilt ähnlich wie bei dem zuvor beschriebenen CIS-System, daß bei konstantem Ga/(In+Ga)-Verhältnis mit abnehmendem Cu-Gehalt die Bandkante abflacht und mit zunehmendem Cu-Gehalt die Transmission sinkt. Kupferreiche Schichten weisen eine erhöhte Rauhigkeit auf, die einen Transmissionverlust verursachen.

Bei Zugabe von Gallium werden zwei Effekte, die für die Anwendung als Steilkantenfilter von besonderem Interesse sind, beobachtet. Zum einen verschiebt sich die Bandkante mit zunehmendem Ga-Anteil zu kürzeren Wellenlängen ohne jedoch die Steilheit der Kante zu beeinflußen. Außerdem reduziert sich bei mittleren Ga-Gehalten gegenüber den reinen CulnS₂ und CuGaS₂ der Streuanteil. Damit ist eine höhere maximale Transmission im Bereich der Absorptionskante gegeben. Beimengungen von Gallium in der Schicht führen somit zu besseren Filtem mit höherer Steilheit und maximaler Transmission.

Der In-Einfluß auf die (Cu, Ag)GaS-Systeme ist ähnlich dem Ga-Einfluß. Die Schichten werden durch In-Zugabe glatter (reduzierte Streuung), d.h. die maximale Transmission wird erhöht.

Bandlücken von 770 (1,61 eV) bis 925 nm (1,34 eV) werden mit dem Materialsystem Cu-In-Ga-Se erzeugt. Die Cu-In-Ga-Se-Schichten wurden bei einer Substrattemperatur von 300 bis 500° C und Aufdampfzeiten von 25 bis 35 min auf das Substrat aufgebracht. Die (In+Ga)/(In+Ga+Cu)-Verhältnisse liegen im Bereich von 0,57 bis 0,67 und die Ga/(In+Ga)-Verhältnisse im Bereich von 0 bis 1.

Für das Materialsystem Cu-Ga-S-Se werden bei einer Substrattemperatur von 550° C, einer Aufdampfzeit von 25 min, Ga/(Ga+Cu)-Verhältnissen zwischen 0,51 und 0,73 und Se/(S+Se)-Verhältnissen zwischen 0 und 1 Bandabstände von 566 (2,13 eV) bis 746 nm (1,66 eV) erreicht.

Der Se-Gehalt hat auf die maximale Transmission und nicht auf die Steilheit der Transmissionskante einen Einfluß. Somit haben Schichten mit kleineren Se-Gehalten gegenüber Schichten mit höheren Se-Gehalten eine reduzierte maximale Transmission, was durch Ausscheidung metallischer Phasen verursacht wird.

Der Bandabstand der Verbindungshalbleiter der Klasse I-III-VI kann vergrößert werden, wenn Kupfer durch Silber ersetzt wird. Ag-In-Ga-S-Schichten wurden bei einer Substrattemperatur von 550° C und einer Aufdampfzeit von 25 min präpariert. Mit den resultierenden (In+Ga)/(In+Ga+Ag)-Verhältnissen von 0,44 bis 0,66 und Ga/(In+Ga)-Verhältnissen von 0 bis 1 könnten Bandlücken von 514 (2,33 eV) bis 673 nm (1,84 eV) erreicht werden.

Im Gegensatz zu dem Cu-In-Ga-S-System ist beim Ag-In-Ga-S-System keine Abhängigkeit der Transmission von der Stöchiometrie feststellbar. Unterschiede werden vor allem bei der Transmission bzw. Streuung beobachtet. Silberreiche Schichten des Ag-In-Ga-S-Verbindungshalbleiters weisen eine höhere Transmission als kupferreiche Schichten des Cu-In-Ga-S-Verbindungshalbleiters auf. Letzteres wird auf die Ausscheidung von Cu₂S zurückgeführt, das eine höhere Streuung verursacht.

Gallium besitzt im Ag-In-Ga-S-System einen ähnlichen Einfluß wie im Cu-In-Ga-S-System, d.h. die Bandkante läßt sich durch Zugaben von Gallium verschieben.

Mit Ag-In-Ga-S-Systemen erhält man vorwiegend gelbe bis hellrote Schichten, d.h. einen Bandabstand von 460 bis 670 nm. Dunkelrote Schichten werden durch Zugabe von Selen erhalten. Das resultierende Materialsystem Ag-In-Ga-S-Se wurde bei einer Substrattemperatur von wiederum 550° C und einer Aufdampfzeit von 30 min mit (In+Ga)/(ln+Ga+Ag)-Verhältnissen von 0,47 bis 0,62, Ga/(In+Ga)-Verhältnissen von 0,34 bis 0,49 und Se/(S+Se)-Verhältnissen von 0,11 bis 0,48 hergestellt. Der Bandabstand liegt für diese Systeme zwischen 755 (1,64 eV) und 789 nm (1,57 eV).

Wie bereits erwähnt, hängen die optischen Eigenschaften neben der Stöchiometrie und der Zusammensetzung auch von der Schichtdicke ab. Zum Vergleich der optischen Eigenschaften verschieden dicker Schichten wurden die Absorptionskoeffizienten herangezogen. Für das CIS-System, das bei 250° C Substrattemperatur aufgebracht wurde, ist für verschiedene Dicken (500 und 900 nm) im Bereich hoher Absorption kein signifikanter Unterschied im Absorptionskoeffizienten zu erkennen. Im Bereich kleiner Absorption ist im Fall der dünneren Schichten eine deutlich höhere Absorption unterhalb der Bandkante vorhanden. Dieser Effekt kann auf eine geringere Kristallinität der dünnen Schichten zurückgeführt werden. Ein derartiges Verhalten wird ebenfalls bei verschieden dicken Schichten, die bei 600° C hergestellt wurden, beobachtet.

Ferner zeigt ein Vergleich der Absorptionen der beiden dünnen Schichten (bei 600° und 250° hergestellt), daß die bei höherer Temperatur abgeschiedene Schicht eine geringere Absorption unterhalb der Bandkante besitzt. Dies gilt analog für die dicken Schichten. Sowohl die Erhöhung der Schichtdicke als auch die Erhöhung der Substrattemperatur tragen zur Verbesserung der optischen Eigenschaften von Steilkantenfiltem bei.

Für die Cu-In-Ga-S-Schichten ist die maximale Transmission im Bereich der Absorptionskante im Fall der dicken Schichten aufgrund der entstehenden Streuung geringer. Dickere Schichten haben zwar die steilere Adsorptionskante, allerdings wird die Transmission von der Streuung limitiert.

Der Einfluß der Schichtdicke bei den Ag-In-Ga-S-Schichten ist stärker ausgeprägt als beim analogen Kupfersystem, da die Schichten schon bei geringerer Dicke (600 nm) stark streuen. Der Trend ist jedoch derselbe wie bei den Kupfersystemen, d.h. mit zunehmender Dicke nimmt die Transmission ab und die Adsorptionskante wird steiler.

Für die wichtigsten Parameter der Schichteigenschaften lassen sich somit nachfolgende Zusammenhänge aufzeigen:

Eine hohe Substrattemperatur verursacht größere Kristallite, die mit einer stärkeren Streuung verbunden sind. Bei niedriger Substrattemperatur werden hingegen defektreiche Schichten gebildet und es kommt zu einer erhöhten Adsorption im Durchlaßbereich. Das Verhältnis Cu, Ag, Al/(In, Ga+Cu, Ag, Al) beeinflußt den Bandabstand und somit die Kantenlage des Filters. Das Verhältnis Cu/Ag, In/Ga, Ga/Al, S/Se und entsprechende Kombinationen ermöglichen die kontinuierliche Einstellung der Adsorptionskante. Abweichungen von der Valenzstöchiometrie Se/Me erhöhen die Adsorption im Durchlaßbereich.

Durch das Aufbringen einer Antireflexschicht, wie z.B. MgF₂ oder Mehrfachschichtsystemen wie zum Beispiel (Al₂O₃, ZrO₂, MgF₂) oder (TiO₂, SiO₂) können die optischen Eigenschaften der Steilkantenfilter weiter verbessert werden. Durch eine derartige Schicht wird die maximale Transmission im Paßbereich erhöht und die Adsorptionskante steiler. Die Adsorptionskante verschiebt sich außerdem um ca. 2 % zu kleineren Wellenlängen. Weitere Verbesserungen sind möglich, indem man statt einfacher Einschichtsysteme entsprechend angepaßte Mehrschichtsysteme zur Entspiegelung verwendet, wobei derartige Schichten nicht die Adsorptionscharakteristik des beschriebenen Materials erzeugen, sondern nur zu einer Verbesserung der Transmission im Paßbereich führen.

Die Tabellen 1 bis 5 enthalten Ausführungsbeispiele für (Cu, Ag)(In, Ga)(S, Se)-Beschichtungen auf hochtransparenten Substraten, (zum Beispiel D 263 der Schott-DESAG AG, Grünenplan), die die Charakteristik von Steilkantenfiltem von 460 bis 1240 nm erfüllen. In Figur 1 ist der Transmissionverlauf für ein (Cu, Ag) (In, Ga) (Se)-System und Antireflexbeschichtung abgebildet. Wie aus dem Transmissionverlauf zu entnehmen, ist ein derartiges System geeignet, Cd-haltiges Rotglas mit einer Kantenwellenlänge λ_{C} von 850 nm zu ersetzen.

**Tabelle 1:**

| Ausführungsbeispiele für Cu-ln-S-Verbindungshalbleiter | | | | | | |
|---|---|---|---|---|---|---|
| Substrat-temperatur [°C] | Aufdampfzeit [min] | In/(In+Cu) | S/(In+Cu) | d (nm) | Bandabstand | |
| | | | | | nm | eV |
| 600 | 30 | 0,53 | 1,01 | 1066 | 860 | 1,44 |
| 600 | 15 | 0,79 | 1,33 | 354 | 854 | 1,45 |
| 600 | 15 | 0,83 | 1,41 | 351 | 746 | 1,66 |
| 600 | 30 | 1,0 | 1,42 | 1088 | 623 | 1,99 |
| 250 | 30 | 0,53 | 1,12 | 896 | 866 | 1,43 |
| 250 | 15 | 0,69 | 1,30 | 393 | 811 | 1,53 |
| 250 | 15 | 0,77 | 1,32 | 380 | 783 | 1,58 |

**Tabelle 2:**

| Ausführungsbeispiele für Cu-(In, Ga)-S-Verbindungshalbleiter | | | | | | | |
|---|---|---|---|---|---|---|---|
| Substrat-temperatur [°C] : | Aufdampfzeit [min] | (In+Ga)/(In+Ga+Cu) | S/(In+Ga+Cu) | Ga/(In+Ga) | d (nm) | Bandabstand | |
| | | | | | | nm | eV |
| 600/550 | 30/13 | 0,54 | 1,11 | 0,11 | 986 | 805 | 1,54 |
| 600/550 | 30/13 | 0,51 | 1,12 | 0,44 | 1269 | 765 | 1,62 |
| 600/550 | 30/13 | 0,58 | 1,26 | 0,40 | 1217 | 685 | 1,81 |
| 600/550 | 30/13 | 0,60 | 1,37 | 1 | 1031 | 506 | 2,44 |

**Tabelle 3:**

| Ausführungsbeispiele für Cu-Ga-S-Se-Verbindungshalbleiter | | | | | | | |
|---|---|---|---|---|---|---|---|
| Substrat-temperatur [°C] | Aufdampfzeit [min] | Ga (Ga+Cu) | (S+Se)/(Ga+Cu) | Se/(S+Se) | d (nm) | Bandabstand | |
| | | | | | | nm | eV |
| 550 | 25 | 0,51 | 1,41 | 0,30 | 579 | 746 | 1,66 |
| 550 | 25 | 0,73 | 1,72 | 0,30 | 406 | 566 | 2,13 |

**Tabelle 4:**

| Ausführungsbeispiele für Cu-In-Ga-Se-Verbindungshalbleiter | | | | | | | |
|---|---|---|---|---|---|---|---|
| Substrat-temperatur [°C] | Aufdampfzeit [min] | (In+Ga)/(In+Ga+Cu) | Se/(In+Ga+Cu) | Ga/(In+Ga) | d (nm) | Bandabstand | |
| | | | | | | nm | eV |
| 300 - 500 | 25 - 35 | 0,57 | 1,06 | 0,46 | 1117 | 925 | 1,34 |
| 300 - 500 | 25 - 35 | 0,66 | 1,24 | 0,80 | 5637 | 770 | 1,61 |

**Tabelle 5:**

| Ausführungsbeispiele für Ag-In-Ga-S-Se-Verbindungshalbleiter | | | | | | | | |
|---|---|---|---|---|---|---|---|---|
| Substrat-temperatur [°C] | Aufdampfzeit [min] | (In+Ga)/(In+Ga+Ag) | (S+Se)/(In+Ga+Ag) | Ga/(In+Ga) | Se/(S+Se) | d (nm) | Bandabstand | |
| | | | | | | | nm | eV |
| 550 | 30 | 0,62 | 1,26 | 0,35 | 0,48 | 703 | 789 | 1,57 |
| 550 | 30 | 0,47 | 1,06 | 0,34 | 0,11 | 838 | 755 | 1,64 |

Die Präparation der (Cu, Ag)(In, Ga)(S, Se)-Schichten erfolgt durch simultane Aufdampfung der Elemente im Hochvakuum auf ein beheiztes Substrat. Über diese sogenannte Koverdampfung (auch Physical Vapor Deposition (PVD) genannt) wird die Zusammensetzung, die Reaktions- und Wachstumsgeschwindigkeit (Schichtdicke) gezielt variiert. Die Elemente Kupfer, Indium und Gallium werden aus einem Graphittiegel und Schwefel und Selen aus einer Edelstahlquelle verdampft. Eine Drehblende deckt das Substrat in der Aufheizphase und bis zur Stabilisisierung der Raten ab. Der Prozeß ist rechnergesteuert und ermöglicht die Kontrolle während der Aufdampfung und die spätere Auswertung. Im Anschluß wird eine Antireflexschicht aufgebracht.

Außer der thermischen Verdampfung der Elemente Kupfer, Indium und Gallium besteht die Möglichkeit, die Substanzen durch Sputtem über die Gasphase auf ein Substrat aufzubringen.

Tabelle 6 beinhaltet Beispiele für Verbindungshalbleiter der Klasse I-II-VI mit aufsteigendem Bandabstand.

**Tabelle 6:**

| Beispiele für Verbindungshalbleiterschichten der Klasse I-III-VI auf hochtransparenten Substraten, die für Cd-freie Steilkantenfilter eingesetzt werden können. | | | | | |
|---|---|---|---|---|---|
| Beispiele | In/(In+Cu) | S/(In+Cu) | d (nm) | Bandabstand | |
| | | | | nm | eV |
| Cu-In-S-Verbindungshalbleiter | 0,53 | 1,12 | 896 | 866 | 1,43 |
| | 0,53 | 1,01 | 1066 | 860 | 1,44 |
| | 0,55 | 1,06 | 1000 | 854 | 1,45 |
| | 0,79 | 1,33 | 354 | 854 | 1,45 |
| | 0,59 | 1,10 | 866 | 849 | 1,46 |
| | 0,56 | 1,06 | 972 | 843 | 1,47 |
| | 0,51 | 1,02 | 1048 | 832 | 1,49 |
| | 0,67 | 1,18 | 695 | 832 | 1,49 |
| | 0,55 | 1,11 | 463 | 829 | 1,49 |
| | 0,70 | 1,26 | 371 | 826 | 1,50 |
| | 0,64 | 1,19 | 392 | 821 | 1,51 |
| | 0,75 | 1,25 | 666 | 815 | 1,52 |
| | 0,69 | 1,30 | 393 | 811 | 1,53 |
| | 0,83 | 1,34 | 651 | 794 | 1,56 |
| | 0,76 | 1,30 | 330 | 789 | 1,57 |
| | 0,77 | 1,32 | 380 | 783 | 1,58 |
| | 0,83 | 1,41 | 351 | 746 | 1,66 |
| | 0,88 | 1,38 | 725 | 733 | 1,69 |
| | 1,00 | 1,42 | 1088 | 623 | 1,99 |

| Beispiele | (In+Ga)/(In+Ga+Cu) | S/(In+Ga+Cu) | Ga/(In+Ga) | d (nm) | Bandabstand | |
|---|---|---|---|---|---|---|
| | | | | | nm | eV |
| Cu-In-Ga-S-Verbindungshalbleiter | 0,54 | 1,11 | 0,11 | 986 | 805 | 1,54 |
| | 0,51 | 1,12 | 0,44 | 1269 | 765 | 1,62 |
| | 0,52 | 1,11 | 0,44 | 1232 | 760 | 1,63 |
| | 0,52 | 1,10 | 0,45 | 1185 | 747 | 1,66 |
| | 0,55 | 1,15 | 0,22 | 1200 | 738 | 1,68 |
| | 0,53 | 1,10 | 0,24 | 1289 | 738 | 1,68 |
| | 0,55 | 1,14 | 0,30 | 1318 | 725 | 1,71 |
| | 0,53 | 1,16 | 0,30 | 863 | 708 | 1,75 |
| | 0,51 | 1,12 | 0,46 | 1164 | 702 | 1,77 |
| | 0,58 | 1,26 | 0,40 | 1217 | 685 | 1,81 |
| | 0,54 | 1,17 | 0,38 | 867 | 681 | 1,82 |
| | 0,54 | 1,26 | 0,50 | 626 | 652 | 1,90 |
| | 0,54 | 1,22 | 0,56 | 804 | 632 | 1,96 |
| | 0,53 | 1,20 | 0,64 | 819 | 596 | 2,08 |
| | 0,60 | 1,80 | 0,44 | 702 | 593 | 2,09 |
| | 0,66 | 1,00 | 1,00 | 1332 | 539 | 2,30 |
| | 0,59 | 2,32 | 0,59 | 1397 | 539 | 2,30 |
| | 0,60 | 1,37 | 1,00 | 1031 | 506 | 2,44 |
| | 0,66 | 1,86 | 0,70 | 1751 | 506 | 2,45 |

| Beispiele | Ga/(Ga+Cu) | (S+Se)/(Ga+Cu) | Se/(S+Se) | d (nm) | Bandabstand | |
|---|---|---|---|---|---|---|
| | | | | | nm | eV |
| Cu-Ga-S-Se-Verbindungshalbleiter | 0,51 | 1,41 | 0,30 | 579 | 746 | 1,66 |
| | 0,56 | 1,34 | 0,58 | 636 | 737 | 1,68 |
| | 0,54 | 1,42 | 0,40 | 595 | 733 | 1,69 |
| | 0,56 | 1,50 | 0,30 | 456 | 590 | 2,10 |
| | 0,73 | 1,72 | 0,30 | 406 | 566 | 2,13 |

| Beispiele | (In+Ga)/(In+Ga+Ag) | S/(In+Ga+Ag) | Ga/(In+Ga) | d (nm) | Bandabstand | |
|---|---|---|---|---|---|---|
| | | | | | nm | eV |
| Ag-In-Ga-S-Verbindungshalbleiter | 0,46 | 1,11 | 0,57 | 473 | 673 | 1,84 |
| | 0,51 | 1,13 | 0,37 | 562 | 639 | 1,94 |
| | 0,46 | 1,15 | 0,37 | 535 | 632 | 1,96 |
| | 0,45 | 1,11 | 0,57 | 314 | 582 | 2,13 |
| | 0,66 | 1,22 | 0,54 | 473 | 576 | 2,15 |
| | 0,44 | 1,48 | 0,51 | 348 | 553 | 2,24 |
| | 0,45 | 1,56 | 0,62 | 257 | 543 | 2,28 |
| | 0,62 | 1,56 | 0,68 | 323 | 514 | 2,33 |
| | 0,49 | 1,45 | 0,69 | 255 | 514 | 2,33 |

| Beispiele | (In+Ga)/(In+Ga+Ag) | (S+Se)/(In+Ga+Ag) | Ga/(In+Ga) | Se/(S+Se) | d (nm) | Bandabstand | |
|---|---|---|---|---|---|---|---|
| | | | | | | nm | eV |
| Ag-In-Ga-S-Se-System | 0,52 | 1,14 | 0,49 | 0,53 | 658 | 789 | 1,57 |
| | 0,62 | 1,26 | 0,35 | 0,48 | 703 | 789 | 1,57 |
| | 0,47 | 1,06 | 0,34 | 0,11 | 838 | 755 | 1,64 |

| Beispiele | (In+Ga)/(In+Ga+Cu) | Se/(In+Ga+Cu) | Ga/(In+Ga) | d (nm) | Bandabstand | |
|---|---|---|---|---|---|---|
| | | | | | nm | eV |
| Cu-In-Ga-Se-System | 0,57 | 1,06 | 0,46 | 1117 | 925 | 1,34 |
| | 0,57 | 1,11 | 0,81 | 6885 | 891 | 1,39 |
| | 0,59 | 1,08 | 0,57 | 2855 | 879 | 1,41 |
| | 0,65 | 1,15 | 0,70 | 4801 | 832 | 1,49 |
| | 0,62 | 1,13 | 0,69 | 3984 | 821 | 1,51 |
| | 0,61 | 1,11 | 0,62 | 2256 | 794 | 1,56 |
| | 0,60 | 1,09 | 0,83 | 6434 | 789 | 1,57 |
| | 0,57 | 1,00 | 0,56 | 2396 | 789 | 1,57 |
| | 0,67 | 1,18 | 0,76 | 4936 | 779 | 1,59 |
| | 0,66 | 1,24 | 0,80 | 5637 | 770 | 1,61 |

Die vorliegende Erfindung stellt Cd-freie optische Steilkantenfilter auf der Basis von Dünnschichten aus Verbindungshalbleitern der Klasse I-III-VI auf, hochtransparenten Glas- oder hochtransparenten und hochtemperaturbeständigen Kunststoffsubstraten zur Verfügung. Bei den Dünnschichten aus den Verbindungshalbleitern der Klasse I-III-VI handelt es sich um polykristallinen Schichten aus Nanokristallen einheitlicher Zusammensetzung. Liegen Nanokristalle mit verschiedenen Zusammensetzungen in einer Schicht vor, so kommt es zu unterschiedlichen Elektronenübergängen, so dass keine Steilkante mit definierter Kantenlage mehr ausgebildet wird. Die Größe der Nanokristalle ist bevorzugt sehr viel kleiner als die Wellenlänge des Lichtes, um Streuung des Lichtes weitgehend zu vermeiden. Die Kristallitgröße ist bevorzugt kleiner 50 nm, besonders bevorzugt kleiner 20 nm, insbesondere kleiner 15 nm, insbesondere bevorzugt kleiner 10 nm. Während die Kristallite eine einheitliche Zusammensetzung zur Ausbildung einer definierten Kantenlage haben, kann Ihre Kristallitgröße eine Kristallitgrößenverteilung aufweisen, ohne dass dies Auswirkungen auf die Lage der Steilkante hat. Beispielsweise kann die Kristallitgröße der Nanokristalle einer Schicht im Bereich 1 bis 10 nm liegen. Liegt die Kristallitgrößenverteilung beispielsweise in diesem Bereich von 1 bis 10 nm wird die Streuung von sichtbarem Licht vermieden. Die mit Verbindungshalbleitern der Klasse I-III-VI beschichteten Substrate stellen eine ökologische Alternative zu den herkömmlichen Cadmium-haltigen Anlaufgläsern dar. Sie zeichnen sich außerdem dadurch aus, daß sie eine gute Sperrung im kurzwelligen Bereich, eine hohe Transmission im langwelligen Bereich und vor allem einen weiten Steilkantenwellenlängenbereich von 460 bis 1240 nm aufweisen. Gegenüber herkömmlichen Steilkantenfiltern können maximale Kantenlagen im langwelligen Bereich von über 850 nm erreicht werden. Bei herkömmlichen Steilkantenfiltern liegt die maximale langwellige Adsorptionskante bei ca. 850 nm.

## Patentansprüche

1. Cadmiumfreier optischer Steilkantenfilter umfassend
I-III-VI-Verbindungshalbleitersysteme mit stöchiometrischer oder nicht-stöchiometrischer Zusammensetzung wobei die I-III-VI-Verbindungshalbleiter Systeme mit einem oder mehreren der nachfolgenden Elemente
für die einwertigen (I)-Elemente: Cu, Ag
für die dreiwertigen (III)-Elemente: Al, In, Ga
für die sechswertigen (VI)-Elemente: S, Se, Te
sind.

2. Cadmiumfreier optischer Steilkantenfilter nach Anspruch 1, **dadurch gekennzeichnet, daß**
der cadmiumfreie optische Steilkantenfilter eine Kantenwellenlänge zwischen 460 nm und 1240 nm aufweist.

3. Cadmiumfreier optischer Steilkantenfilter nach einem der Ansprüche 1 bis 2, **dadurch gekennzeichnet, daß**
der optische Steilkantenfilter wenigstens ein transparentes Substrat sowie wenigstens eine darauf abgeschiedene Schicht umfassend ein I-III-VI-Verbindungshalbleitersystem mit stöchiometrischer oder nicht-stöchiometrischer Zusammensetzung aufweist.

4. Cadmiumfreier optischer Steilkantenfilter nach Anspruch 3, **dadurch gekennzeichnet, daß**
das transparente Substrat ein Glassubstrat ist.

5. Cadmiumfreier optischer Steilkantenfilter nach Anspruch 3, **dadurch gekennzeichnet, daß**
das transparente Substrat ein Kunststoffsubstrat ist.

6. Cadmiumfreier optischer Steilkantenfilter nach Anspruch 4, **dadurch**
**gekennzeichnet, daß**
das Glassubstrat ein Ti-dotiertes Kalk-Natrium-Glas umfaßt.

7. Cadmiumfreier optischer Steilkantenfilter nach einem der Ansprüche 3 bis 6, **dadurch gekennzeichnet, daß**
das System aus wenigstens einem Substrat und wenigstens einer Schicht umfassend einen I-III-VI-Verbindungshalbleiter, des weiteren eine antireflektierende Schicht oder ein antireflektierendes Schichtsystem umfasst.

8. Cadmiumfreier optischer Steilkantenfilter nach einem der Ansprüche 3 bis 7, **dadurch gekennzeichnet, daß**
der Steilkantenfilter zwischen dem wenigstens einen transparenten Substrat und der wenigstens einen I-III-VI-Verbindungshalbleiterschicht eine Haftvermittlerschicht umfaßt.

9. Cadmiumfreier optischer Steilkantenfilter nach einem der Ansprüche 3 bis 8, **dadurch gekennzeichnet, daß**
auf beiden Seiten des transparenten Substrates wenigstens eine Verbindungshalbleiterschicht und/oder Funktionsfilterschicht aufgebracht ist.

10. Cadmiumfreier optischer Steilkantenfilter nach einem der Ansprüche 3 bis 8 **dadurch gekennzeichnet, daß**
auf der einen Seite des transparenten Substrates wenigstens
eine Verbindungshalbleiterschicht und/oder Funktionsfilterschicht aufgebracht ist und auf der anderen Seite eine IR-Cut-Schicht für Bandfilter im IR-Bereich.

11. Cadmiumfreier optischer Steilkantenfilter gemäß Anspruch 9,
**dadurch gekennzeichnet, daß**
die Verbindungshalbleiterschichten auf den beiden Substratseiten unterschiedliche Dicke und/oder Stöchiometrie aufweisen.

12. Cadmiumfreier optischer Steilkantenfilter gemäß einem der
Ansprüche 3 bis 11, **dadurch gekennzeichnet, daß**
die Verbindungshalbleiterschicht und/oder Antireflexschicht eine mit Hilfe eines Sputter-Verfahrens aufgebrachte Schicht ist.

13. Cadmiumfreier optischer Steilkantenfilter gemäß einem der
Ansprüche 1 bis 12, **dadurch gekennzeichnet, daß**
der Steilkantenfilter eine Kantenwellenlänge > 850 nm aufweist.

14. Cadmiumfreier optischer Steilkantenfilter nach einem der
Ansprüche 1 bis 12, **dadurch gekennzeichnet, daß**
der Cadmiumfreie optische Steilkantenfilter eine Kantenwellenlänge < 460 nm aufweist und eine Halbleiterverbindung des Systems Cu-Al-Se oder Cu-Al-S oder Cu-Al-S/Se.

15. Cadmiumfreier optischer Steilkantenfilter nach einem der Ansprüche
1 bis 12, **dadurch gekennzeichnet, daß**
der Verbindungshalbleiter ein temäres System Cu-In-Se ist, wobei In/(In+Cu) zwischen 0,5 und 1,0 liegt und der Filter eine Kantenwellenlänge zwischen 983 und 623 nm aufweist.

16. Cadmiumfreier optischer Steilkantenfilter nach einem der Ansprüche
1 bis 12, **dadurch gekennzeichnet, daß**
der Verbindungshalbleiter ein ternäres System Cu-In-Se ist, wobei In/(In+Cu) zwischen 0,5 und 1,0 liegt und der Filter eine Kantenwellenlänge zwischen 1192 und 919 nm aufweist.

17. Cadmiumfreier optischer Steilkantenfilter nach einem der Ansprüche
1 bis 12, **dadurch gekennzeichnet, daß**
der Verbindungshalbleiter ein ternäres System Cu-Ga-S ist, wobei Ga/(Ga+Cu) zwischen 0,5 und 1,0 liegt und der Filter eine Kantenwellenlänge zwischen 504 und 460 nm aufweist.

18. Cadmiumfreier optischer Steilkantenfilter nach einem der Ansprüche
1 bis 12, **dadurch gekennzeichnet, daß**
der Verbindungshalbleiter ein temäres System Cu-Ga-Se ist, wobei Ga/(Ga+Cu) zwischen 0,5 und 1,0 liegt und der Filter eine Kantenwellenlänge zwischen 738 und 646 nm aufweist.

19. Cadmiumfreier optischer Steilkantenfilter nach einem der Ansprüche
1 bis 12, **dadurch gekennzeichnet, daß**
der Verbindungshalbleiter ein temäres System Ag-In-S ist, wobei In/(In+Ag) zwischen 0,5 und 1,0 liegt und der Filter eine Kantenwellenlänge zwischen 653 und 564 nm aufweist.

20. Cadmiumfreier optischer Steilkantenfilter nach einem der Ansprüche
1 bis 12, **dadurch gekennzeichnet, daß**
der Verbindungshalbleiter ein ternäres System Ag-In-Se ist, wobei In/(In+Ag) zwischen 0,5 und 1,0 liegt und der Filter eine Kantenwellenlänge zwischen 992 und 919 nm aufweist.

21. Cadmiumfreier optischer Steilkantenfilter nach einem der Ansprüche
1 bis 12, **dadurch gekennzeichnet, daß**
der Verbindungshalbleiter ein ternäres System Ag-Ga-S ist, wobei Ga/(Ga+Ag) zwischen 0,5 und 1,0 liegt und der Filter eine Kantenwellenlänge zwischen 466 und 460 nm aufweist.

22. Cadmiumfreier optischer Steilkantenfilter nach einem der Ansprüche
1 bis 12, **dadurch gekennzeichnet, daß**
der Verbindungshalbleiter ein temäres System Ag-Ga-Se ist, wobei Ga/(Ga+Ag) zwischen 0,5 und 1,0 liegt und der Filter eine Kantenwellenlänge zwischen 689 und 646 nm aufweist.

23. Verfahren zur Herstellung cadmiumfreier optischer Steilkantenfilter umfassend ein Substrat sowie eine hierauf aufgebrachte Schicht mit einem Verbindungshalbleiter umfassend die folgenden Schritte:
23.1 das Substrat wird auf eine Substrattemperatur im Bereich 200° C bis 800° C, bevorzugt 250° C bis 600° C aufgeheizt
23.2 auf das geheizte Substrat wird mittels Physical Vapor Deposition (PVD) oder einem Sputter-Prozeß ein I-III-VI-Verbindungshalbleiter aufgebracht.

24. Verfahren nach Anspruch 23, **dadurch gekennzeichnet, daß** auf die I-III-VI-Verbindungshalbleiterschicht eine antireflektierende Schicht, insbesondere aus MgF₂ oder Mehrfachschichtsystem, insbesondere aus (MgF₂, Al₂O₃, ZrO₂), (TiO₂, SiO₂) aufgebracht wird.

25. Verfahren nach einem der Ansprüche 23 bis 24,
**dadurch gekennzeichnet, daß**
auf die I-III-VI-Verbindungshalbleiterschicht oder auf die I-III-VI-Verbindungshalbleiterschicht und die antireflektierende Schicht
bzw. das antireflektierende Schichtsystem eine Schutzschicht oder ein Schutzschichtsystem, insbesondere aus SiO₂, Lacken oder Kunststoff aufgebracht wird.
